# EUROPEAN PATENT APPLICATION

(11) **EP 4 546 345 A1**
(43) Date of publication of application: **30.04.2025**
(21) Application number: 23841931.1
(22) Date of filing: 05.06.2023
(51) Int. Cl.: G11C 29/52, G06F 11/07

(54) **PROCESSOR, INFORMATION ACQUISITION METHOD, SINGLE BOARD AND NETWORK DEVICE**

(30) Priority: 19.07.2022 CN 202210847565; 26.09.2022 CN 202211175885
(71) Applicant: Huawei Technologies Co., Ltd., Shenzhen, Guangdong 518129 (CN)
(72) Inventor: LIAO, Youqing, Shenzhen, Guangdong 518129 (CN); CHEN, Haiwu, Shenzhen, Guangdong 518129 (CN); GAI, Chengxu, Shenzhen, Guangdong 518129 (CN)
(74) Representative: Epping - Hermann - Fischer
(86) International application number: PCT/CN2023/098211
(87) International publication number: WO 2024/016864

(57) **Abstract**

A processor, a method for obtaining information, a board, and a network device are provided, and relate to the field of computer technologies. The processor includes a control module (101), a first register (102), and a cache (103), and the processor is communicatively connected to a reset-safe non-volatile storage medium (104, 105). The control module (101) is configured to: obtain a reset indication, where the reset indication is an indication generated when the processor runs abnormally (S401); further configured to obtain related information of the processor based on the reset indication, where the related information includes at least one of register information of the first register (102) or data stored in the cache (103) (S402); and further configured to store the related information in the reset-safe non-volatile storage medium (104, 105) (S403). When the processor runs abnormally, the control module (101) inside the processor can obtain the related information of the processor based on the reset indication, so that reliability of a manner of obtaining the related information is high. In addition, the control module (101) can obtain comprehensive related information, and when a cause of abnormal running of the processor is analyzed based on the related information, accuracy of the analyzed cause is high.

## Description

This application claims priority to Chinese Patent Application No. 202210847565.8, filed on July 19, 2022 and entitled "METHOD FOR LOCATING PROCESSOR SUSPENSION PROBLEM AND COMPUTER SYSTEM", which is incorporated herein by reference in its entirety. This application further claims priority to Chinese Patent Application No. 202211175885.X, filed on September 26, 2022 and entitled "PROCESSOR, METHOD FOR OBTAINING INFORMATION, BOARD, AND NETWORK DEVICE", which is incorporated herein by reference in its entirety.

### TECHNICAL FIELD

This application relates to the field of computer technologies, and in particular, to a processor, a method for obtaining information, a board, and a network device.

### BACKGROUND

As a module configured to perform an operation and control in a computer system, whether the processor runs normally is an important factor that affects whether the computer system can normally perform an operation and control. Therefore, when the processor runs abnormally, related information of the processor needs to be obtained, to analyze a cause of abnormal running of the processor.

### SUMMARY

This application provides a processor, a method for obtaining information, a board, and a network device, to obtain related information of the processor, so as to analyze a cause of abnormal running of the processor.

According to a first aspect, a processor is provided. The processor includes a control module, a first register, and a cache, and the processor is communicatively connected to a reset-safe non-volatile storage medium. The control module is configured to: obtain a reset indication generated when the processor runs abnormally; obtain related information of the processor based on the reset indication, where the related information includes at least one of register information of the first register or data stored in the cache; and store the related information in the reset-safe non-volatile storage medium.

When the processor runs abnormally, the control module inside the processor can obtain the related information of the processor based on the reset indication. The processor does not need to rely on an external module to obtain the related information of the processor, and does not need to rely on an operating system (operating system, OS) to execute an interrupt response program in response to an interrupt signal. Therefore, reliability of a manner in which the processor obtains the related information is high. In addition, when the control module obtains the register information of the first register and the data stored in the cache, the obtained related information is comprehensive. Therefore, when a cause of abnormal running of the processor is analyzed based on the related information, accuracy of the analyzed cause is high. In addition, because the control module may be a hardware module, after obtaining the reset indication, the control module can quickly obtain the related information of the processor, so that efficiency of obtaining the related information is high.

In a possible implementation, the processor further includes a second register. The second register is a register used when the processor runs. The first register is configured to record register information of the second register. The first register is a reset-safe non-volatile register. The reset indication indicates to reset the processor. The control module is configured to indicate, based on the reset indication, the first register to stop recording the register information of the second register, and after the processor is reset based on the reset indication, obtain the register information of the first register. The reset-safe non-volatile first register is used to record the register information of the second register. After the processor is reset, the register information of the second register may be reserved in the first register, so that the cause of abnormal running of the processor can be analyzed based on the obtained register information of the first register. The first register is used to reserve the register information of the second register, so that reliability of a manner of reserving the register information of the second register is high.

In a possible implementation, the second register includes at least one of a program counter (program counter, PC), a stack pointer (stack pointer, SP), a frame pointer (frame pointer, FP), a control register (control register, CR), or a link register (link register, LR). Types of the second register are rich and flexible, and the processor can reserve register information of a plurality of types of registers.

In a possible implementation, the processor has a reset pin. The reset pin is configured to generate the reset indication and transmit the reset indication to the control module. The reset pin configured to generate the reset indication is disposed, so that a manner in which the processor generates the reset indication is simple.

In a possible implementation, the control module is communicatively connected to a reset module. The reset module is configured to send the reset indication to the control module. The control module may further obtain the reset indication by receiving the reset indication sent by the reset module, and a manner in which the processor obtains the reset indication is flexible.

In a possible implementation, the reset-safe non-volatile storage medium includes at least one of a reset-safe non-volatile memory inside the processor, a non-volatile storage medium inside the processor, a reset-safe non-volatile memory outside the processor, or a non-volatile storage medium outside the processor. A type of the reset-safe non-volatile storage medium is flexible. Therefore, an architecture of the processor may be flexible and diversified, provided that the control module can store the related information of the processor in the reset-safe non-volatile storage medium.

In a possible implementation, the control module is further configured to: after the processor is reset, obtain the related information from the reset-safe non-volatile storage medium, and generate a running abnormality record based on the related information. The running abnormality record is generated, so that the cause of abnormal running of the processor can be obtained. In addition, when the related information includes the register information of the first register and the data stored in the cache, accuracy of the analyzed cause is high.

According to a second aspect, a method for obtaining information is provided. The method is applied to a processor. The processor includes a control module, a first register, and a cache, and the processor is communicatively connected to a reset-safe non-volatile storage medium. The method includes: The control module obtains a reset indication generated when the processor runs abnormally; obtains related information of the processor based on the reset indication, where the related information includes at least one of register information of the first register or data stored in the cache; and stores the related information in the reset-safe non-volatile storage medium.

In a possible implementation, the processor further includes a second register. The second register is a register used when the processor runs. The first register is configured to record register information of the second register. The first register is a reset-safe non-volatile register. The reset indication indicates to reset the processor. The obtaining related information of the processor based on the reset indication includes: indicating, based on the reset indication, the first register to stop recording the register information of the second register; and obtaining the register information of the first register after the processor is reset based on the reset indication.

In a possible implementation, the second register includes at least one of a PC, an SP, an FP, a CR, or an LR.

In a possible implementation, the processor has a reset pin. The method further includes: The processor generates the reset indication via the reset pin; and transmits the reset indication to the control module via the reset pin. The obtaining a reset indication includes: receiving the reset indication.

In a possible implementation, the control module is communicatively connected to a reset module. The reset module is configured to send the reset indication to the control module. The obtaining a reset indication includes: receiving the reset indication sent by the reset module.

In a possible implementation, the reset-safe non-volatile storage medium includes at least one of a reset-safe non-volatile memory inside the processor, a non-volatile storage medium inside the processor, a reset-safe non-volatile memory outside the processor, or a non-volatile storage medium outside the processor.

In a possible implementation, the method further includes: After the processor is reset, the control module obtains the related information from the reset-safe non-volatile storage medium, and generates a running abnormality record based on the related information.

According to a third aspect, a board is provided. The board includes any one of the processors in the first aspect and a reset-safe non-volatile storage medium communicatively connected to the processor.

In a possible implementation, the board further includes a reset module, the reset module is communicatively connected to a control module in the processor, and the reset module is configured to send a reset indication to the control module.

According to a fourth aspect, a network device is provided. The network device includes at least one processor in the first aspect and a reset-safe non-volatile storage medium communicatively connected to the processor.

In a possible implementation, the network device further includes a reset module, the reset module is communicatively connected to a control module in the processor, and the reset module is configured to send a reset indication to the control module.

According to a fifth aspect, a network device is provided. The network device includes at least one board in the third aspect.

According to a sixth aspect, a chip is provided. The chip includes at least one processor in the first aspect and a reset-safe non-volatile storage medium communicatively connected to the processor.

In a possible implementation, the chip further includes a reset module, the reset module is communicatively connected to a control module in the processor, and the reset module is configured to send a reset indication to the control module.

In a possible implementation, the chip further includes an input interface, an output interface, and a storage. The storage includes the foregoing reset-safe non-volatile storage medium. The input interface, the output interface, the processor, and the storage are connected through an internal connection path.

It should be understood that, for beneficial effects achieved by the technical solutions of the second aspect to the sixth aspect of this application and corresponding possible implementations, refer to the technical effects of the first aspect and corresponding possible implementations of the first aspect. Details are not described herein again.

### BRIEF DESCRIPTION OF DRAWINGS

FIG. 1 is a diagram of a structure of a processor according to an embodiment of this application;
FIG. 2 is a diagram of a structure of another processor according to an embodiment of this application;
FIG. 3 is a diagram of a structure of still another processor according to an embodiment of this application;
FIG. 4 is a flowchart of a method for obtaining information according to an embodiment of this application;
FIG. 5 is a diagram in which a first register records register information of a second register according to an embodiment of this application;
FIG. 6 is a diagram of a process of obtaining related information according to an embodiment of this application;
FIG. 7 is a diagram of a structure of a network device according to an embodiment of this application;
FIG. 8 is a diagram of a structure of another network device according to an embodiment of this application;
FIG. 9 is a diagram of a structure of still another network device according to an embodiment of this application; and
FIG. 10 is a diagram of a structure of yet another network device according to an embodiment of this application.

### DESCRIPTION OF EMBODIMENTS

Terms used in implementations of this application are merely used to explain embodiments of this application, but are not intended to limit this application. The following describes embodiments of this application with reference to the accompanying drawings.

With the development of computer technologies, a processor is used in a computer system in a plurality of forms. For example, a processor having a plurality of cores (cores) is widely used in devices such as a server and a terminal. For another example, a processor system including a plurality of processors is used in the computer system, and the processor system is configured to provide higher computing performance, higher data processing performance, higher artificial intelligence inference performance, higher artificial intelligence training performance, and the like.

When the processor runs abnormally, for example, the processor is suspended, related information of the processor needs to be obtained to analyze a cause of abnormal running of the processor. Processor suspension may refer to a case in which the processor cannot normally execute a program due to interrupt nesting, a program fleet (program fleet), or a program deadloop (deadloop). The related information of the processor may include related information of a moment when the processor runs abnormally. When the processor runs abnormally, the related information of the processor may also be referred to as field information of a running abnormality. Some running abnormalities may cause the processor to restart, causing the field information to be overwritten. The field information cannot be obtained by generating a log (log) or alarm information, or obtaining an error record stored in a memory. As a result, a specific cause of abnormal running of the processor cannot be analyzed. Therefore, when the processor runs abnormally, how to effectively obtain the related information of the processor to analyze the specific cause of abnormal running of the processor is a problem that needs to be urgently resolved.

In a related technology 1, a manner of obtaining related information of a processor based on a watchdog (watchdog) chip is provided. In the related technology 1, the watchdog chip is connected to an input/output (input/output, I/O) pin of the processor, and the processor periodically sends, to the watchdog chip via the I/O pin, an input signal of a high/low level transition. If the processor runs abnormally, the processor cannot send an input signal to the watchdog chip. In this case, the watchdog chip sends a reset signal to a controller. After receiving the reset signal, the controller first sends an interrupt signal to the processor, and an OS running on the processor responds to the interrupt signal, and runs an interrupt response program to collect register information that causes abnormal running of the processor. After sending the interrupt signal for a period of time, the controller sends the reset signal to the processor to trigger the processor, for example, a central processing unit (central processing unit, CPU), to be reset.

In a related technology 2, a manner of obtaining related information of a processor based on a coprocessor is provided. In the related technology 2, a processor is connected to a built-in coprocessor or an external coprocessor through a bus. When the coprocessor senses that the processor runs abnormally, the coprocessor actively accesses the processor through the bus, to obtain register information that causes abnormal running of the processor.

The related technology 1 depends on reliable running of the watchdog chip and the controller, and the OS running on the processor can respond to the interrupt signal. When running reliability of the watchdog chip or the controller is low, or an abnormality occurs when the processor executes the interrupt response program, reliability of the related technology 1 is low. The related technology 2 depends on a reliable connection between the coprocessor and the processor. When reliability of a bus connection is low, reliability of the related technology 2 is low. In addition, in both the related technology 1 and the related technology 2, only the register information is obtained, information used to analyze a cause of abnormal running of the processor is limited, and accuracy of the analyzed cause is low.

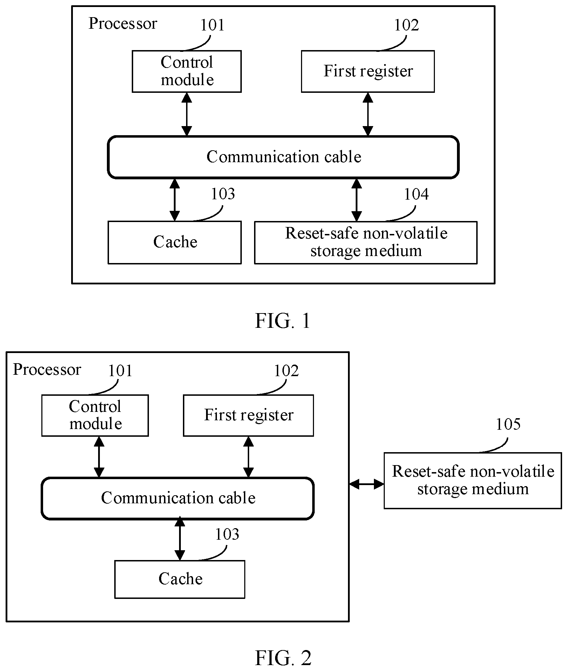

An embodiment of this application provides a processor, configured to obtain comprehensive related information when the processor runs abnormally, so that accuracy of an analyzed cause is high. FIG. 1 is a diagram of a structure of a processor according to an embodiment of this application. As shown in FIG. 1, the processor includes a control module 101, a first register 102, and a cache (cache) 103. The control module 101, the first register 102, and the cache 103 are communicatively connected. For example, as shown in FIG. 1, the control module 101, the first register 102, and the cache 103 are communicatively connected through a communication cable in the processor. The control module 101 is configured to obtain a reset indication. The reset indication is an indication generated when the processor runs abnormally. The control module 101 is further configured to obtain related information of the processor based on the reset indication. The related information includes at least one of register information of the first register 102 or data stored in the cache 103. For example, the processor is communicatively connected to a reset-safe non-volatile storage medium, and the control module 101 is further configured to store the related information of the processor in the reset-safe non-volatile storage medium.

Based on the structure of the processor, a case in which the control module 101 obtains the reset indication includes but is not limited to a case 1 and a case 2.

In the case 1, the processor has a reset pin. The reset pin is configured to generate the reset indication and transmit the reset indication to the control module 101.

For the case 1, the control module 101 may obtain the reset indication by receiving the reset indication transmitted via the reset pin. The reset pin may be a hard reset pin or a soft reset pin. This is not limited in embodiments of this application. The reset pin may be configured to generate the reset indication based on a low-level signal. For example, the processor is disposed on a board. When the board senses that the processor runs abnormally, the board reduces a level of the reset pin, so that the processor generates the reset indication via the reset pin based on the low-level signal. The reset pin is disposed, so that the processor can quickly respond to the low-level signal, to improve efficiency of generating the reset indication. In this embodiment of this application, the board may be any circuit component including the processor. For example, the board is a circuit component including the processor, a resistor, and a capacitor. A manner in which the board senses that the processor runs abnormally is not limited in embodiments of this application. For example, a watchdog chip is further disposed on the board, and the watchdog chip is configured to sense that the processor runs abnormally. The processor periodically sends an input signal to the watchdog chip. When the processor runs abnormally, the processor stops sending the input signal to the watchdog chip. The watchdog chip generates an output signal based on a case in which no input signal is received. The output signal indicates that the processor runs abnormally.

In the case 2, the control module 101 is communicatively connected to a reset module, and the reset module is configured to send the reset indication to the control module 101.

For the case 2, the control module 101 may obtain the reset indication by receiving the reset indication sent by the reset module. The reset module may be located inside the processor, or may be located outside the processor. In this embodiment of this application, the reset module is disposed at a flexible location. For example, the reset module is either of control logic and a control circuit inside the processor, or either of control logic and a control circuit outside the processor. The control logic may alternatively be a software program executed on a software module in the processor. Regardless of whether the reset module is located inside the processor or outside the processor, the reset module may be configured to generate the reset indication based on a first signal, and send the reset indication to the control module 101. For example, the reset module is communicatively connected to a watchdog chip, and the watchdog chip is further communicatively connected to the processor. The processor periodically sends an input signal to the watchdog chip based on first duration. The first duration may be set based on experience or an actual requirement. This is not limited in embodiments of this application. When the processor runs abnormally, the processor stops sending the input signal to the watchdog chip, or an interval between time of sending two input signals by the processor is greater than the first duration. The watchdog chip generates an output signal based on a case in which a next input signal is not received within the first duration after an input signal is received, and sends the output signal as the first signal to the reset module, so that the reset module generates the reset indication based on the first signal and sends the reset indication to the control module 101.

In a possible implementation, the processor further includes a second register. The second register is a register used when the processor runs. The first register 102 is configured to record register information of the second register. The first register 102 is a reset-safe non-volatile register. The reset indication obtained by the control module 101 indicates to reset the processor. In this case, the control module 101 is configured to indicate, based on the reset indication, the first register 102 to stop recording the register information of the second register, and obtain the register information of the first register 102 after the processor is reset based on the reset indication, to obtain the related information of the processor. A quantity of first registers 102 and a quantity of second registers are not limited in embodiments of this application. When the processor includes a plurality of second registers, the processor also includes a plurality of first registers 102, and one first register 102 is configured to record register information of one or more second registers. In this embodiment of this application, the first register 102 may be configured to record the register information of the second register in real time. In other words, each time the register information of the second register changes in a process in which the processor runs a program, the first register 102 corresponding to the second register records changed register information. For example, the second register is a PC, and register information of the PC includes a PC pointer. In a process in which the processor runs a program, each time the PC pointer points to a new instruction, the first register 102 corresponding to the PC records a changed PC pointer. A function of recording the register information of the second register in real time by the first register 102 may be referred to as a real-time backup recording function of the first register 102.

For example, regardless of the reset indication generated via the reset pin or the reset indication generated via the reset module, the reset indication may indicate to reset the processor after a reference time period. The reference time period may be set based on experience or a moment requirement. For example, when the register information of the first register is obtained as the related information of the processor, the reference time period is greater than or equal to duration required for indicating the first register 102 to stop recording the register information of the second register. When the data stored in the cache 103 is obtained as the related information of the processor, the reference time period is greater than or equal to duration required for the control module 101 to obtain the data stored in the cache 103. For example, when the data stored in the cache 103 is obtained as the related information of the processor, the reference time period is greater than or equal to second duration. The second duration is a sum of the duration required for the control module 101 to obtain the data stored in the cache 103 and duration required for the control module 101 to store the data in the cache 103 in the reset-safe non-volatile storage medium. The reference time period greater than or equal to the second duration is set, so that it can be ensured that the control module 101 stores the data stored in the cache 103 in the reset-safe non-volatile storage medium, to ensure reliable storage of obtained data.

In a possible implementation, the second register in the processor includes at least one of a PC, an SP, an FP, a CR, or an LR. Register information of the PC includes but is not limited to at least one PC pointer. The at least one PC pointer may include a PC pointer of a currently running target instruction, PC pointers of the first A instructions that are before the target instruction and that are adjacent to the target instruction, and a PC pointer of the last B instructions that are after the target instruction and that are adjacent to the target instruction. A and B are both positive integers. Register information of the SP includes but is not limited to a call stack. Register information of the FP includes but is not limited to a call frame. Register information of the CR includes but is not limited to at least one of a system control flag for controlling an operation mode and a state of the processor, a linear address that causes a page fault (page fault), or a physical memory base address (page-directory base address) of a page directory table. Register information of the LR includes but is not limited to a difference between a value of the PC and a reference value when a running abnormality occurs. The reference value may be set based on experience or an actual requirement. The reference value is not limited in embodiments of this application.

In correspondence to the foregoing several types of second registers, a first register 102 configured to record the register information of the PC may be referred to as a backup program counter (backup PC, BPC), a first register 102 configured to record the register information of the SP may be referred to as a backup stack pointer (backup SP, BSP), a first register 102 configured to record the register information of the FP may be referred to as a backup frame pointer (backup FP, BFP), a first register 102 configured to record the register information of the CR may be referred to as a backup control register (backup CR, BCR), and a first register 102 configured to record the register information of the LR may be referred to as a backup link register (backup LR, BLR). When one first register 102 is configured to record register information of a plurality of second registers, the first register 102 may have a plurality of names. For example, if a first register 102 is configured to record the register information of the PC and the register information of the SP, the first register 102 may be referred to as a BPC or a BSP.

The foregoing several second registers are intended to describe types of registers used when the processor runs. In addition to the foregoing several second registers, another type of register used when the processor runs may also be used as the second register. In this case, the processor further includes a first register 102 corresponding to a second register of another type, to record register information of the second register of the another type.

For example, the reset-safe non-volatile storage medium communicatively connected to the processor includes but is not limited to at least one of a reset-safe non-volatile memory inside the processor, a non-volatile storage medium inside the processor, a reset-safe non-volatile memory outside the processor, or a non-volatile storage medium outside the processor.

In a possible implementation, in the structure of the processor shown in FIG. 1, the reset-safe non-volatile storage medium is a reset-safe non-volatile storage medium 104 located inside the processor. The reset-safe non-volatile storage medium 104 is communicatively connected to another module in the processor through a communication cable inside the processor, to be communicatively connected to the processor. As shown in FIG. 1, the reset-safe non-volatile storage medium 104 is communicatively connected to the control module 101, the first register 102, and the cache 103 through the communication cable inside the processor. The reset-safe non-volatile storage medium 104 includes but is not limited to a reset-safe non-volatile memory and a non-volatile storage medium. The reset-safe non-volatile memory includes but is not limited to a static random access memory (static random access memory, SRAM). The non-volatile storage medium includes but is not limited to at least one of a double data rate synchronous dynamic random access memory (double data rate synchronous dynamic random access memory, DDR SDRAM), a flash card (flash card), a secure digital memory (secure digital memory, SD) card, a serial advanced technology attachment (serial advanced technology attachment, SATA) card, or a universal serial bus card (universal serial bus, USB card). SATAis a serial hardware drive interface based on industry standards.

In another possible implementation, in a structure of a processor shown in FIG. 2, the reset-safe non-volatile storage medium is a reset-safe non-volatile storage medium 105 located outside the processor. The reset-safe non-volatile storage medium 105 includes but is not limited to a reset-safe non-volatile memory and a non-volatile storage medium. A principle of the reset-safe non-volatile memory is the same as that of the reset-safe non-volatile memory described above, and details are not described herein again. The non-volatile storage medium includes but is not limited to at least one of a DDR SDRAM, a flash card, an SD card, a SATA card, or a universal serial bus card outside the processor. The reset-safe non-volatile storage medium 105 may further include a storage medium in another processor or board. For example, the processor is communicatively connected to the another processor or board through a channel such as an Ethernet, so that the processor is communicatively connected to the storage medium in the another processor or board. In this way, the reset-safe non-volatile storage medium 105 includes the storage medium in the another processor or board. The storage medium in the another processor or board includes but is not limited to at least one of a volatile storage medium or a non-volatile storage medium.

For example, the control module 101 is further configured to: after the processor is reset, obtain the related information of the processor from the reset-safe non-volatile storage medium, and generate a running abnormality record based on the related information. For example, when the reset-safe non-volatile storage medium stores the register information of the first register 102, the control module 101 is further configured to: after the processor is reset, obtain the register information of the first register 102 from the storage medium, and generate the running abnormality record based on the register information of the first register 102. When the storage medium stores the data stored in the cache 103, the control module 101 is further configured to: after the processor is reset, obtain the data from the storage medium, and generate the running abnormality record based on the data.

The foregoing descriptions are provided by using the control module 101 as an entire module. In this embodiment of this application, the control module 101 may include a plurality of control submodules, and functions of the control module 101 are implemented by the plurality of control submodules. For example, the control module 101 includes a first control submodule, a second control submodule, and a third control submodule. The first control submodule is configured to obtain the register information of the first register 102 based on the reset indication, and store the register information of the first register 102 in the reset-safe non-volatile storage medium. The second control submodule is configured to obtain, based on the reset indication, the data stored in the cache 103, and store the data stored in the cache 103 in the reset-safe non-volatile storage medium. The third control submodule is configured to obtain the related information of the processor from the reset-safe non-volatile storage medium, and generate the running abnormality record based on the related information. For example, the first control submodule and the second control submodule are both hardware modules, and the third control submodule is a software module. The first control submodule and the second control submodule may be implemented in a same hardware module, or may be respectively implemented in different hardware modules. This is not limited in embodiments of this application.

When the processor provided in this embodiment of this application runs abnormally, the control module 101 inside the processor can obtain the related information of the processor based on the reset indication. The processor does not need to rely on an external module to obtain the related information of the processor, and does not need to rely on an OS to execute an interrupt response program in response to an interrupt signal. Therefore, reliability of a manner in which the processor obtains the related information is high. In addition, when the control module 101 obtains the register information of the first register 102 and the data stored in the cache 103, the obtained related information is comprehensive. Therefore, when a cause of abnormal running of the processor is analyzed based on the related information, accuracy of the analyzed cause is high. In addition, when the control module is a hardware module, after obtaining the reset indication, the control module can quickly obtain the related information of the processor, so that efficiency of obtaining the related information is high.

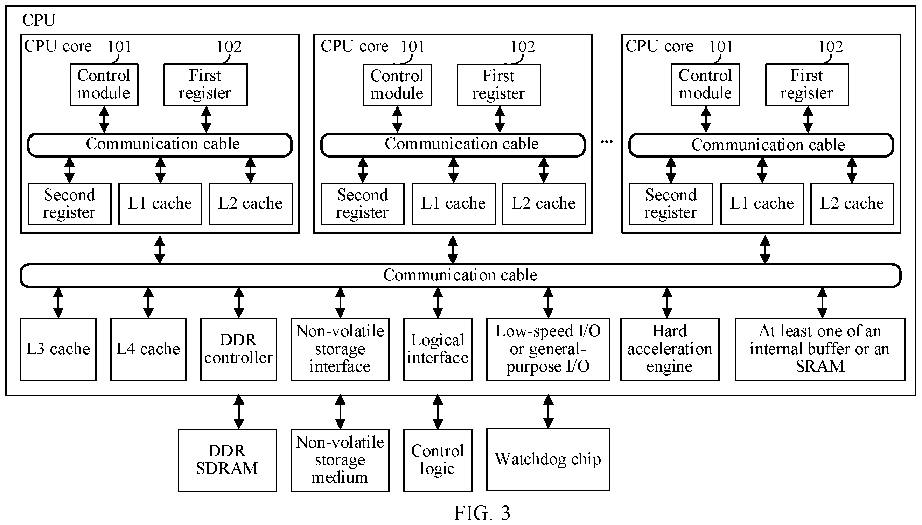

The processor provided in this embodiment of this application may be a CPU, and the processor may further include another module other than the foregoing modules. FIG. 3 is a diagram of a structure of still another processor according to an embodiment of this application. As shown in FIG. 3, a CPU includes at least one CPU core, and a control module 101, a first register 102, and a second register are included in each CPU core. A cache 103 includes a plurality of levels of caches. As shown in FIG. 3, the plurality of levels of caches include a level (level, L) 1 cache, an L2 cache, an L3 cache, and an L4 cache. The L1 cache and the L2 cache are located in each CPU core, and the L3 cache and the L4 cache are located outside each CPU core. The processor may further include at least one of an internal buffer (buffer) or an internal SRAM, a hard acceleration engine configured to implement hardware acceleration, a DDR controller configured to control a DDR SDRAM, a non-volatile storage interface configured to communicatively connect to a non-volatile storage medium, a logical interface configured to communicatively connect to control logic, and a low-speed I/O or a general-purpose I/O configured to communicatively connect to a watchdog chip. Modules in the processor may be connected through a communication cable in the processor. Modules in the CPU core are communicatively connected through a communication cable in the CPU core, and modules in the CPU are communicatively connected through a communication cable in the CPU.

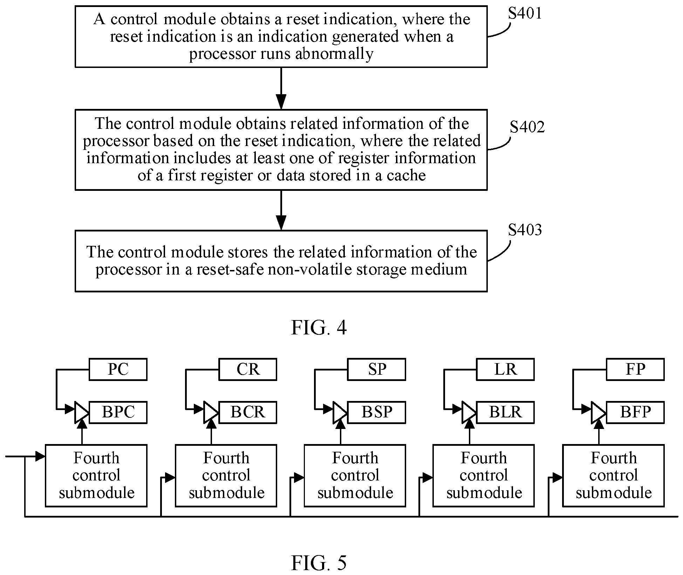

An embodiment of this application further provides a method for obtaining information. The method is applied to the processor shown in the foregoing embodiment. As shown in FIG. 4, the method includes but is not limited to S401 to S403.

S401: A control module obtains a reset indication, where the reset indication is an indication generated when the processor runs abnormally.

**In** a possible implementation, the processor has a reset pin. The method further includes: The processor generates the reset indication via the reset pin, and transmits the reset indication to the control module via the reset pin. **In** this case, the obtaining a reset indication includes: receiving the reset indication. As described in the foregoing embodiment for the reset pin, the reset pin of the processor may be a hard reset pin or a soft reset pin. When the reset pin receives a low-level signal, the reset indication may be generated based on the reset pin. For example, when the processor is disposed on a board, the board may sense that the processor runs abnormally, so that when the board senses that the processor runs abnormally, the board reduces a level of the reset pin, to input a low-level signal to the reset pin.

In another possible implementation, the control module is communicatively connected to a reset module. The reset module is configured to send the reset indication to the control module. In this case, the obtaining a reset indication includes: receiving the reset indication sent by the reset module. As described in the foregoing embodiment for the reset module, the reset module may be located inside the processor, or may be located outside the processor. The reset module may be further communicatively connected to a watchdog chip, and the watchdog chip is further communicatively connected to the processor. For example, the processor periodically sends an input signal to the watchdog chip based on first duration. When the processor runs abnormally, the processor stops sending the input signal to the watchdog chip, or an interval between time of sending two input signals by the processor is greater than the first duration. The watchdog chip generates an output signal based on a case in which a next input signal is not received within first duration after an input signal is received, and sends the output signal as a first signal to the reset module. The reset module generates the reset indication based on the first signal, and sends the reset indication to the control module. The control module receives the reset indication sent by the reset module to obtain the reset indication. A location of the watchdog chip is not limited in embodiments of this application. The watchdog chip may be disposed in the processor, or may be disposed outside the processor.

S402: The control module obtains related information of the processor based on the reset indication, where the related information includes at least one of register information of a first register or data stored in a cache.

For example, after receiving the reset indication, the control module directly performs an operation of obtaining, based on the reset indication, the data stored in the cache. After the control module obtains the data stored in the cache, the processor is reset. The reset indication may further indicate to reset the processor after a reference time period. When the data stored in the cache is obtained as the related information of the processor, the reference time period is greater than or equal to duration required for the control module to obtain the data stored in the cache. The reference time period may alternatively be greater than or equal to second duration. The second duration is a sum of duration required for the control module to obtain the data stored in the cache and duration required for the control module to store the data in the cache in a reset-safe non-volatile storage medium. The reference time period greater than or equal to the second duration is set, so that it can be ensured that the control module stores the data stored in the cache in the reset-safe non-volatile storage medium, to ensure reliable storage of obtained data.

For example, the processor further includes a second register. The second register is a register used when the processor runs. The first register is configured to record register information of the second register. The first register is a reset-safe non-volatile register. The reset indication indicates to reset the processor. The obtaining related information of the processor based on the reset indication includes: indicating, based on the reset indication, the first register to stop recording the register information of the second register; and obtaining the register information of the first register after the processor is reset based on the reset indication. A principle of the second register is the same as that of the second register in related content in the foregoing embodiment, and details are not described herein again. The reset indication may further indicate to reset the processor after the reference time period. When the register information of the first register is obtained as the related information of the processor, the reference time period is greater than or equal to duration required for indicating the first register to stop recording the register information of the second register.

In this embodiment of this application, the control module may obtain both the register information of the first register and the data stored in the cache. For example, the control module obtains, based on the reset indication, the data stored in the cache and indicates the first register to stop recording the register information of the second register, and obtains the register information of the first register after the processor is reset based on the reset indication. In other words, in this case, if the reset indication indicates to reset the processor after the reference time period, the reference time period is greater than or equal to the duration required for the control module to obtain the data stored in the cache, and is greater than or equal to the duration required for indicating the first register to stop recording the register information of the second register. Certainly, the reference time period may alternatively be greater than or equal to the second duration, and greater than or equal to the duration required for indicating the first register to stop recording the register information of the second register.

S403: The control module stores the related information of the processor in the reset-safe non-volatile storage medium.

The reset-safe non-volatile storage medium may be located inside the processor, or may be located outside the processor. The reset-safe non-volatile storage medium includes but is not limited to at least one of a reset-safe non-volatile memory inside the processor, a non-volatile storage medium inside the processor, a reset-safe non-volatile memory outside the processor, or a non-volatile storage medium outside the processor. For example, when the reset-safe non-volatile storage medium is located inside the processor, to be specific, when the reset-safe non-volatile storage medium includes at least one of the reset-safe non-volatile memory inside the processor or the non-volatile storage medium inside the processor, the control module stores, through a communication cable inside the processor, the related information of the processor in the reset-safe non-volatile storage medium. When the reset-safe non-volatile storage medium is located outside the processor, to be specific, when the reset-safe non-volatile storage medium includes the reset-safe non-volatile memory outside the processor or the non-volatile storage medium outside the processor, the control module stores, through a communication connection between the processor and the reset-safe non-volatile storage medium, the related information of the processor in the reset-safe non-volatile storage medium.

In a possible implementation, the method further includes: after the processor is reset, the control module obtains the related information of the processor from the reset-safe non-volatile storage medium, and generates a running abnormality record based on the related information. For example, the control module obtains the register information of the first register and the data stored in the cache from the reset-safe non-volatile storage medium, and generates the running abnormality record based on the obtained register information and data. The running abnormality record may include the obtained register information and data. To be specific, when the first register includes a BPC, a BSP, a BFP, a BLR, and a BCR, the running abnormality record may include the obtained data, register information of the BPC, register information of the BSP, register information of the BFP, register information of the BLR, and register information of the BCR. The register information of the BPC includes but is not limited to at least one PC pointer. The register information of the BSP includes but is not limited to a call stack. The register information of the BFP includes but is not limited to a call frame. The register information of the BLR includes but is not limited to a difference between a value of a PC and a reference value when a running abnormality occurs. The register information of the BCR includes but is not limited to at least one of a system control flag for controlling an operation mode and a state of the processor, a linear address that causes a page fault, or a physical memory base address of a page directory table.

In the method provided in this embodiment of this application, when the processor runs abnormally, the control module in the processor can obtain the related information of the processor based on the obtained reset indication. Therefore, there is no need to rely on an external module of the processor to obtain the related information of the processor, and there is no need to rely on an OS to execute an interrupt response program in response to an interrupt signal. Therefore, reliability of a manner of obtaining the related information is high. In addition, when the register information of the first register and the data stored in the cache are obtained, comprehensive related information can be obtained in the method. Therefore, when a cause of abnormal running of the processor is analyzed based on the related information, accuracy of the analyzed cause is high. In addition, when the control module is a hardware module, after obtaining the reset indication, the control module can quickly obtain the related information of the processor, so that efficiency of obtaining the related information is high.

An embodiment of this application further provides a board. The board includes any one of the foregoing processors and a reset-safe non-volatile storage medium communicatively connected to the processor. For example, the board includes an indication module. The indication module is configured to send a first instruction to a control module of the processor. The first instruction indicates the control module to indicate a first register to start to record register information of a second register. FIG. 5 is a diagram in which a first register records register information of a second register. Refer to FIG. 5. A control module includes a plurality of fourth control submodules, and one fourth control submodule is configured to indicate one first register to start to record register information of a second register corresponding to the first register. An indication module of a board is configured to synchronously send a first instruction to the plurality of fourth control submodules, so that the plurality of fourth control submodules can synchronously indicate a plurality of first registers to start to record register information of second registers corresponding to the plurality of first registers. As shown in FIG. 5, the plurality of first registers include a BPC, a BCR, a BSP, a BLR, and a BFP. The BPC corresponds to a PC, the BCR corresponds to a CR, the BSP corresponds to an SP, the BLR corresponds to an LR, and the BFP corresponds to an FP. It should be noted that as shown in FIG. 5, it is intended to describe how the first register records the register information of the second register, and not intended to limit a type of the first register and a quantity of first registers of each type. There may be one or more first registers of a same type.

**In** a possible implementation, the board further includes a storage module. The storage module is configured to store a running abnormality record. For example, after obtaining the running abnormality record, the control module of the processor may transmit the running abnormality record to the storage module of the board, and the storage module of the board stores the running abnormality record. For example, the storage module of the board is at least one of a reset-safe non-volatile memory outside the processor or a non-volatile storage medium outside the processor. The board may further include the reset module in the foregoing embodiment, and the reset module is not described herein again.

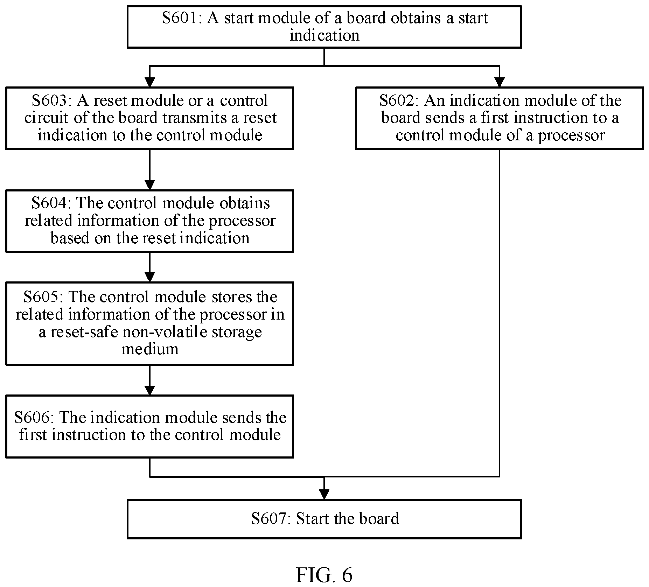

The following uses an example in which the board includes one of the foregoing processors to describe a process of obtaining related information of the processor. FIG. 6 is a diagram of a process of obtaining related information according to an embodiment of this application. As shown in FIG. 6, the method includes but is not limited to S601 to S607.

S601: A start module of a board obtains a start indication.

The start module may be a start interface of the board, and the start interface is configured to receive the start indication. The start indication includes but is not limited to a cold start indication and a hot start indication. The cold start indication refers to a start indication received by the start interface when the board is powered off. For example, when the board is powered off, the start interface is powered on to receive the cold start indication. The hot start indication refers to a start indication received by the start interface when the board is not powered off. For example, when a watchdog chip disposed on the board senses that a processor runs abnormally, the watchdog chip generates an output signal, and the output signal is used as the hot start indication. For a manner in which the watchdog chip senses that the processor runs abnormally, refer to the descriptions in the foregoing embodiment. Details are not described herein again. In response to obtaining the cold start indication, S602 is performed. In response to obtaining the hot start indication, S603 is performed.

S602: An indication module of the board sends a first instruction to a control module of the processor.

For example, in response to obtaining the cold start indication, the indication module sends the first instruction to the control module. The first instruction indicates the control module to indicate a first register to start to record register information of a second register, so that the control module can indicate, based on the first instruction, the first register to start to record the register information of the second register.

S603: A reset module or a control circuit of the board transmits a reset indication to the control module.

In a possible implementation, the watchdog chip disposed on the board is further configured to be used as the reset module in the foregoing embodiment. To be specific, the watchdog chip is communicatively connected to the control module, and after generating the hot start indication, the watchdog chip sends the reset indication to the control module based on the hot start indication. In another possible implementation, the watchdog chip is only configured to sense that the processor runs abnormally, and generate the hot start indication when sensing that the processor runs abnormally. The board further has the control circuit. The control circuit is configured to reduce a level of a reset pin of the processor based on the hot start indication, so that the processor generates a reset signal based on a low-level signal via the reset pin, and transmits the reset indication to the control module via the reset pin.

In this embodiment of this application, because the reset indication is obtained based on the hot start indication, the reset indication may also be referred to as a hot reset indication, and a reset performed by the processor based on the hot reset indication may be referred to as a hot reset of the processor.

S604: The control module obtains related information of the processor based on the reset indication.

A principle of S604 is the same as that of S402 in related content, and details are not described herein again.

S605: The control module stores the related information of the processor in a reset-safe non-volatile storage medium.

A principle of S605 is the same as that of S403, and details are not described herein again.

S606: The indication module sends the first instruction to the control module.

A principle of S606 is the same as that of S602 in related content, and details are not described herein again.

S607: Start the board.

For example, regardless of the cold start indication or the hot start indication, after S602 or S603 to S606 are performed, the control module indicates the first register to start to record the register information of the second register. After the control module indicates the first register to start to record the register information of the second register, the board is started. Starting the board means that all modules and components of the board are started and run.

The board provided in this embodiment of this application includes any one of the foregoing processors. When the processor runs abnormally, the control module in the processor can obtain the related information of the processor based on the obtained reset indication. Therefore, there is no need to rely on an external module of the processor to obtain the related information of the processor, and there is no need to rely on an OS to execute an interrupt response program in response to an interrupt signal. Therefore, reliability of a manner of obtaining the related information is high. In addition, when register information of the first register and data stored in a cache are obtained, the obtained related information is comprehensive. Therefore, when a cause of abnormal running of the processor is analyzed based on the related information, accuracy of the analyzed cause is high. When the control module is a hardware module, after obtaining the reset indication, the control module can quickly obtain the related information of the processor, so that efficiency of obtaining the related information is high. In addition, because a coprocessor configured to obtain the related information of the processor does not need to be disposed, design complexity of the board is low, and costs are also low.

An embodiment of this application further provides a network device. The network device includes at least one processor in the foregoing embodiment and a reset-safe non-volatile storage medium communicatively connected to the processor. For example, the network device further includes a reset module. The reset module is communicatively connected to a control module in the processor, and the reset module is configured to send a reset indication to the control module. Because the processor provided in this embodiment of this application may alternatively be disposed on a board, this embodiment of this application further provides the network device. The network device includes at least one board in the foregoing embodiment. The network device may be a box-shaped device, and the box-shaped device is a network device including only one of the foregoing boards. Alternatively, the network device may be a frame-shaped device. The frame-shaped device is a network device including a main control board and at least one of the foregoing boards. The main control board is connected to the at least one board through an inter-board management channel, and the main control board is configured to control the at least one board in the network device.

Based on different cases of the network device, a process of obtaining information includes but is not limited to the following case A and case B.

In the case A, the network device is the case-shaped device.

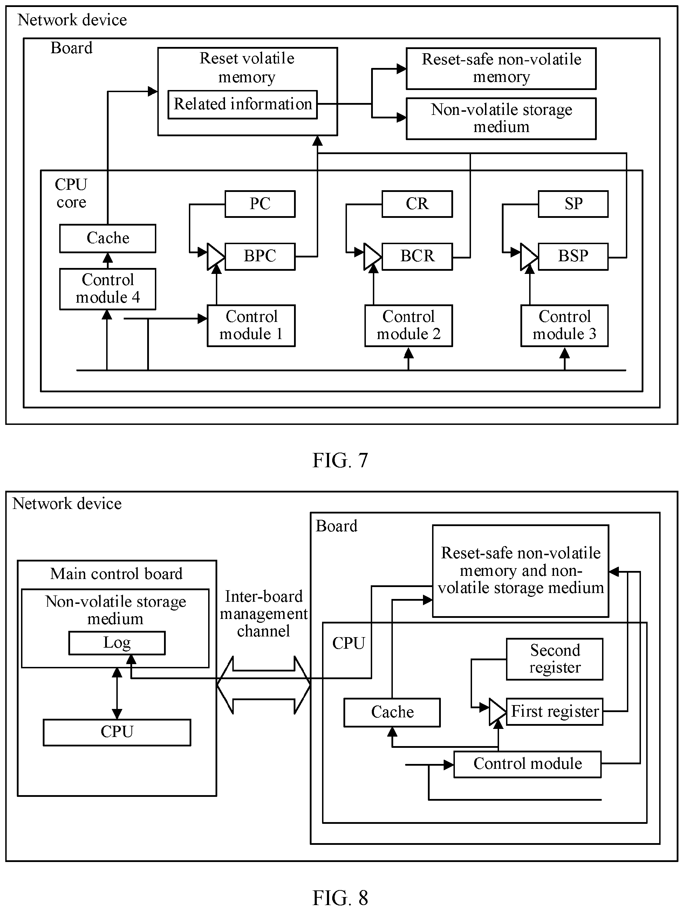

FIG. 7 is a diagram of a structure of a network device according to an embodiment of this application. The network device includes one board, in other words, the network device is a box-shaped device. A processor included in the board may be a microcontroller unit (microcontroller unit, MCU) or a CPU. When the processor is the MCU, the MCU has a built-in CPU core, a built-in reset volatile memory, and a built-in reset-safe non-volatile storage medium. When the processor is the CPU, the CPU has a built-in CPU core. The CPU may further have at least one of a built-in reset volatile memory or a built-in reset-safe non-volatile storage medium. Certainly, at least one of the built-in reset volatile memory or the built-in reset-safe non-volatile storage medium may alternatively be located outside the CPU. As shown in FIG. 7, the reset-safe non-volatile storage medium includes a reset-safe non-volatile memory and a non-volatile storage medium. The CPU core, the reset volatile memory, and the reset-safe non-volatile storage medium are all hardware modules.

As shown in FIG. 7, the CPU core includes a cache, a PC, a CR, an SP, a BPC, a BCR, a BSP, and a control module 1 to a control module 4. The control module 1 is configured to indicate the BPC to start to record register information of the PC or stop recording register information of the PC, obtain register information of the BPC based on a reset indication, and store the register information of the BPC in a reset-safe non-volatile storage medium. The control module 2 is configured to indicate the BCR to start to record register information of the CR or stop recording register information of the CR, obtain register information of the BCR based on the reset indication, and store the register information of the BCR in the reset-safe non-volatile storage medium. The control module 3 is configured to indicate the BSP to start to record register information of the SP or stop recording register information of the SP, obtain register information of the BSP based on the reset indication, and store the register information of the BSP in the reset-safe non-volatile storage medium. The control module 4 is configured to obtain, based on the reset indication, data stored in the cache, and store the data stored in the cache in the reset-safe non-volatile storage medium. A start module, an indication module, a watchdog chip, a reset module, and a control circuit included in the board are not shown in FIG. 7.

Quantities and types of first registers, second registers, and control modules are merely used as examples for description, and are not intended to limit quantities and types of first registers, second registers, and control modules included in the network device.

For example, for the case A, the process of obtaining information includes the following S701 to S707.

S701: The start module of the board obtains a cold start indication.

A principle of S701 is the same as that in related content of obtaining the cold start indication in S601, and details are not described herein again.

S702: The indication module of the board sends a first instruction to the control module of the processor.

In response to receiving the cold start indication, S702 is performed. A principle of S702 is the same as that of S602 in related content, and details are not described herein again. For example, when the first register includes the BPC, the BCR, and the BSP, and the second register includes the PC, the CP, and the SP, the first instruction indicates the control module 1 to indicate the BPC to start to record the register information of the PC, further indicates the control module 2 to indicate the BCR to start to record the register information of the CR, and further indicates the BSP to start to record the register information of the SP.

S703: The control module indicates, based on the first instruction, the first register to start to record register information of the second register.

For example, the control module sends a trigger signal to the first register based on the first instruction. The trigger signal indicates the first register to start to record the register information of the second register. A form of the trigger signal is not limited in this application. For the network device shown in FIG. 7, the control module 1 sends the trigger signal to the BPC based on the first instruction. The trigger signal indicates the BPC to start to record the register information of the PC. The control module 2 sends the trigger signal to the BCR based on the first instruction. The trigger signal indicates the BCR to start to record the register information of the CR. The control module 3 sends the trigger signal to the BSP based on the first instruction. The trigger signal indicates the BSP to start to record the register information of the SP.

S704: Start the board.

A principle of S704 is the same as that of S607 in related content, and details are not described herein again.

S705: The watchdog chip in the board senses that the CPU runs abnormally, and the reset module or the control circuit of the board transmits the reset indication to the control module.

A principle of S705 is the same as that of S603 in related content, and details are not described herein again.

S706: The control module obtains related information of the processor based on the reset indication.

For example, a principle of S706 is the same as that of S402 and S604 in related content. For example, for the network device shown in FIG. 7, the control module 4 obtains, based on the reset indication, the data stored in the cache. The control module 1 indicates, based on the reset indication, the BPC to stop recording the register information of the PC. The control module 2 indicates, based on the reset indication, the BCR to stop recording the register information of the CR. The control module 3 indicates, based on the reset indication, the BSP to stop recording the register information of the SP. The processor is reset based on the reset indication. After the processor is reset based on the reset indication, the control module 1 obtains the register information of the BPC, the control module 2 obtains the register information of the BCR, and the control module 3 obtains the register information of the BSP.

S707: The control module stores the related information of the processor in the reset-safe non-volatile storage medium.

For example, a principle of S707 is the same as that of S403 and S605 in related content. For example, for the network device shown in FIG. 7, the control module 1 stores the register information of the BPC in the reset-safe non-volatile storage medium, the control module 2 stores the register information of the BCR in the reset-safe non-volatile storage medium, the control module 3 stores the register information of the BSP in the reset-safe non-volatile storage medium, and the control module 4 stores the data stored in the cache in the reset-safe non-volatile storage medium.

Regardless of which type of the related information, when storing the related information in the reset-safe non-volatile storage medium, the control module may first store the related information in the reset volatile memory, and then store the related information in the reset-safe non-volatile storage medium via the reset volatile memory.

In a possible implementation, after the control module stores the related information of the processor in the reset-safe non-volatile storage medium, the control module further obtains the related information stored in the storage medium, and generates a running abnormality record based on the related information. For example, the control module obtains at least one stored PC pointer, at least one stored call stack, and at least one stored physical memory base address of a page directory table from the storage medium, and generates the running abnormality record based on the at least one obtained PC pointer, the at least one obtained call stack, and the at least one obtained physical memory base address of the page directory table. For example, after generating the running abnormality record, the control module further stores the running abnormality record in the reset-safe non-volatile storage medium.

In the case B, the network device is the frame-shaped device.

FIG. 8 is a diagram of a structure of another network device according to an embodiment of this application. The network device includes a main control board and one board, in other words, the network device is a frame-shaped device. Refer to FIG. 8. The main control board includes a CPU and a non-volatile storage medium, and the non-volatile storage medium may be configured to store a log. The board includes the CPU and a reset-safe non-volatile storage medium. The reset-safe non-volatile storage medium includes a reset-safe non-volatile memory and the non-volatile storage medium. Locations of the CPU, the reset-safe non-volatile memory, and the non-volatile storage medium are the same as those in a principle in related content in FIG. 7, and details are not described herein again. The CPU and the reset-safe non-volatile storage medium are both hardware modules. As shown in FIG. 8, the CPU includes a cache, a first register, a second register, and a control module. A start module, an indication module, a watchdog chip, a reset module, and a control circuit included in the board are not shown in FIG. 8.

For example, for the case B, the process of obtaining information includes the following S801 to S807.

S801: The start module of the board obtains a cold start indication.

A principle of S801 is the same as that in related content of obtaining the cold start indication in S601 and S701. For example, for the network device shown in FIG. 8, the main control board powers on the start module of the board through an inter-board management channel, to transmit the cold start indication to the start module of the board, so that the start module of the board can obtain the cold start indication.

S802: The indication module of the board sends a first instruction to the control module of the processor.

In response to receiving the cold start indication, S802 is performed. For example, for the network device shown in FIG. 8, the cold start indication further indicates the indication module of the board to send the first instruction to the control module of the processor. To be specific, the main control board indicates, through the inter-board management channel, the indication module of the board to send the first instruction to the control module of the processor. Certainly, the indication module may alternatively automatically send the first instruction to the control module based on the received cold start indication. A manner of triggering the indication module to send the first instruction to the control module is flexible.

S803: The control module indicates, based on the first instruction, the first register to start to record register information of the second register.

A principle of S803 is the same as that of S703 in related content, and details are not described herein again.

S804: Start the board.

A principle of S804 is the same as that of S607 and S704 in related content, and details are not described herein again.

S805: The watchdog chip in the board senses that the CPU runs abnormally, and the reset module or the control circuit of the board transmits the reset indication to the control module.

A principle of S805 is the same as that of S603 and S705 in related content, and details are not described herein again.

S806: The control module obtains related information of the processor based on the reset indication.

A principle of S806 is the same as that of S402, S604, and S706 in related content, and details are not described herein again.

S807: The control module stores the related information of the processor in the reset-safe non-volatile storage medium.

For example, a principle of S807 is the same as that of S403 and S605 in related content. For example, for the network device shown in FIG. 8, the control module stores register information of the first register in the reset-safe non-volatile storage medium of the board, and the control module further stores data stored in the cache in the reset-safe non-volatile storage medium of the board.

In a possible implementation, after the control module stores the related information of the processor in the reset-safe non-volatile storage medium, the control module further obtains the related information stored in the storage medium, and generates a running abnormality record based on the related information. For example, after generating the running abnormality record, the control module further stores the running abnormality record in the reset-safe non-volatile storage medium. For example, for the network device shown in FIG. 8, after generating the running abnormality record, the control module stores the running abnormality record in the non-volatile storage medium of the main control board through the inter-board management channel. In the non-volatile storage medium, the running abnormality record may be stored in a form of a log.

The network device provided in this embodiment of this application includes any one of the foregoing processors. When the processor runs abnormally, the control module in the processor can obtain the related information of the processor based on the obtained reset indication. Therefore, there is no need to rely on an external module of the processor to obtain the related information of the processor, and there is no need to rely on an OS to execute an interrupt response program in response to an interrupt signal. Therefore, reliability of a manner of obtaining the related information is high. In addition, when register information of the first register and data stored in a cache are obtained, the obtained related information is comprehensive. Therefore, when a cause of abnormal running of the processor is analyzed based on the related information, accuracy of the analyzed cause is high. When the control module is a hardware module, after obtaining the reset indication, the control module can quickly obtain the related information of the processor, so that efficiency of obtaining the related information is high. In addition, because a coprocessor configured to obtain the related information of the processor does not need to be disposed, design complexity of the board provided in this embodiment of this application is low, and costs are also low. Therefore, design complexity of the network device including the board is low, and costs are also low.

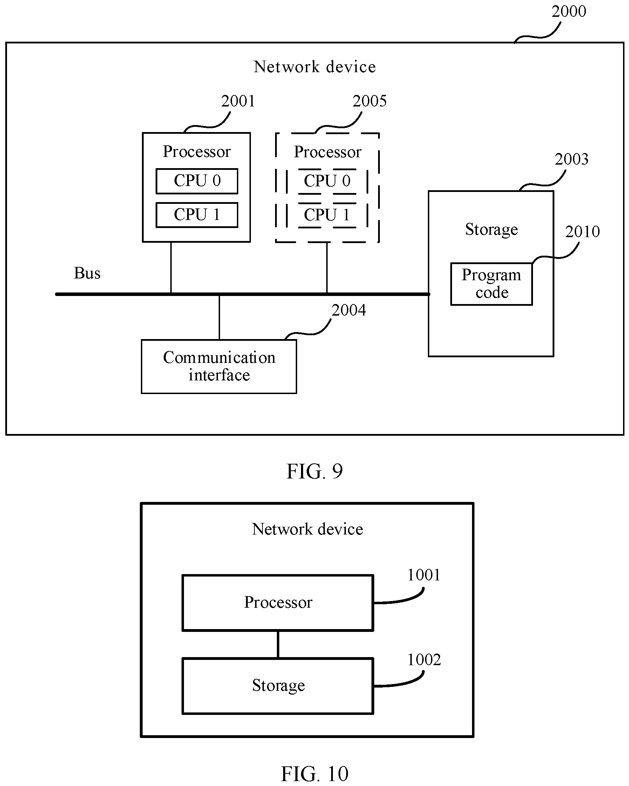

FIG. 9 is a diagram of a structure of still another network device according to an embodiment of this application. The processor shown in any one of FIG. 1 to FIG. 3 is configured in the network device 2000 shown in FIG. 9, and the processor is configured to perform the method for obtaining information shown in FIG. 4. The network device 2000 is, for example, a switch, a router, a server, or a terminal. The network device 2000 may be implemented by a general bus architecture.

As shown in FIG. 9, the network device 2000 includes at least one processor 2001, a storage 2003, and at least one communication interface 2004. The processor 2001 may be the processor shown in any one of FIG. 1 to FIG. 3.

The processor 2001 is, for example, a CPU, a digital signal processor (digital signal processor, DSP), a network processor (network processor, NP), a graphics processing unit (graphics processing unit, GPU), a neural-network processing unit (neural-network processing unit, NPU), a data processing unit (data processing unit, DPU), a microprocessor, or one or more integrated circuits configured to implement the solutions of this application. For example, the processor 2001 includes an application-specific integrated circuit (application-specific integrated circuit, ASIC), a programmable logic device (programmable logic device, PLD), or another programmable logic device, a transistor logic device, a hardware component, or any combination thereof. The PLD is, for example, a complex programmable logic device (complex programmable logic device, CPLD), a field programmable logic gate array (field programmable gate array, FPGA), a generic array logic (generic array logic, GAL), or any combination thereof. The processor may implement or perform various logical blocks, modules, and circuits described with reference to content disclosed in embodiments of this application. Alternatively, the processor may be a combination implementing a computing function, for example, a combination including one or more microprocessors, or a combination of the DSP and the microprocessor.

Optionally, the network device 2000 further includes a bus. The bus is configured to transmit information between components of the network device 2000. The bus may be a peripheral component interconnect (peripheral component interconnect, PCI for short) bus, an extended industry standard architecture (extended industry standard architecture, EISA for short) bus, or the like. The bus may include an address bus, a data bus, a control bus, or the like. For ease of representation, only one thick line is used to represent the bus in FIG. 9, but this does not mean that there is only one bus or only one type of bus.

The storage 2003 is, for example, a read-only memory (read-only memory, ROM) or another type of static storage device that can store static information and instructions, for another example, a random access memory (random access memory, RAM) or another type of dynamic storage device that can store information and instructions, for another example, an electrically erasable programmable read-only memory (electrically erasable programmable read-only memory, EEPROM), a compact disc read-only memory (compact disc read-only memory, CD-ROM) or another optical disk storage, an optical disk storage (including a compact disc, a laser disc, an optical disc, a digital versatile disc, a Blu-ray disc, or the like), a magnetic disk storage medium or another magnetic storage device, or any other medium that can be used to carry or store expected program code in a form of an instruction or a data structure and that can be accessed by a computer, but is not limited thereto. For example, the storage 2003 exists independently, and is connected to the processor 2001 through the bus. Alternatively, the storage 2003 and the processor 2001 may be integrated together.

The communication interface 2004 is any apparatus such as a transceiver, and is configured to communicate with another device or a communication network. The communication network may be an Ethernet, a radio access network (RAN), a wireless local area network (wireless local area network, WLAN), or the like. The communication interface 2004 may include a wired communication interface, and may further include a wireless communication interface. Specifically, the communication interface 2004 may be an Ethernet (Ethernet) interface, a fast Ethernet (fast Ethernet, FE) interface, a gigabit Ethernet (gigabit Ethernet, GE) interface, an asynchronous transfer mode (asynchronous transfer mode, ATM) interface, a WLAN interface, a cellular network communication interface, or a combination thereof. The Ethernet interface may be an optical interface, an electrical interface, or a combination thereof. In this embodiment of this application, the communication interface 2004 may be used by the network device 2000 to communicate with another device.

In a specific implementation, in an embodiment, the processor 2001 may include one or more CPUs, for example, a CPU 0 and a CPU 1 shown in FIG. 9. Each of the processors may be a single-core (single-CPU) processor, or may be a multi-core (multi-CPU) processor. The processor herein may be one or more devices, circuits, and/or processing cores configured to process data (for example, computer program instructions).

In a specific implementation, in an embodiment, the network device 2000 may include a plurality of processors, for example, the processor 2001 and a processor 2005 shown in FIG. 9. Each of the processors may be a single-core (single-CPU) processor, or may be a multi-core (multi-CPU) processor. The processor herein may be one or more devices, circuits, and/or processing cores configured to process data (for example, computer program instructions).

In a specific implementation, in an embodiment, the network device 2000 may further include an output device and an input device. The output device communicates with the processor 2001, and may display information in a plurality of manners. For example, the output device may be a liquid crystal display (liquid crystal display, LCD), a light emitting diode (light emitting diode, LED) display device, a cathode ray tube (cathode ray tube, CRT) display device, or a projector (projector). The input device communicates with the processor 2001, and may receive an input from a user in a plurality of manners. For example, the input device may be a mouse, a keyboard, a touchscreen device, or a sensing device.

In some embodiments, the storage 2003 is configured to store program code 2010 for executing the solutions of this application, and the processor 2001 may execute the program code 2010 stored in the storage 2003. The program code 2010 may include one or more software modules. Optionally, the processor 2001 may also store program code or instructions for performing the solutions of this application.

Steps of the method for obtaining information shown in FIG. 4 are completed by using an integrated logic circuit of the processor or instructions in a form of software. The steps of the method disclosed with reference to embodiments of this application may be directly performed and completed by a hardware processor, or may be performed and completed by a combination of hardware and software modules in the processor. The software module may be located in a storage medium that is mature in the art, such as a random access memory, a flash memory, a read-only memory, a programmable read-only memory, an electrically erasable programmable memory, or a register. The storage medium is located in the storage. The processor reads information in the storage and completes the steps of the methods in combination with hardware thereof. To avoid repetition, details are not described herein again.

For example, FIG. 10 is a diagram of a structure of yet another network device according to an embodiment of this application. The network device includes the processor shown in any one of FIG. 1 to FIG. 3. The processor is configured to perform the steps of the method for obtaining information shown in FIG. 4. For example, the network device is, for example, a server or a terminal. The network device may have a large difference due to different configurations or performance, and may include one or more processors 1001 and one or more storages 1002. The one or more storages 1002 store at least one computer program, and the at least one computer program is loaded and executed by the one or more processors 1001. Certainly, the network device may further have components such as a wired or wireless network interface, a keyboard, and an input/output interface, to perform input/output. The network device may further include another component configured to implement a function of the device. Details are not described herein.

An embodiment of this application further provides a communication apparatus. The apparatus includes a transceiver, a storage, and a processor. The transceiver, the storage, and the processor communicate with each other through an internal connection path. The storage is configured to store instructions. The processor is configured to execute the instructions stored in the memory, to control the transceiver to receive a signal and control the transceiver to send a signal. In addition, when the processor executes the instructions stored in the storage, the processor is enabled to perform a method for obtaining information.

It should be understood that the processor may be a CPU, or may be another general-purpose processor, a DSP, an ASIC, an FPGA, or another programmable logic device, a discrete gate or a transistor logic device, a discrete hardware component, or the like. The general-purpose processor may be a microprocessor or any conventional processor or the like. It should be noted that the processor may be a processor that supports an advanced reduced instruction set computer machines (advanced RISC machines, ARM) architecture.

Further, in an optional embodiment, the storage may include a read-only memory and a random access memory, and provide instructions and data for the processor. The storage may further include a non-volatile random access memory. For example, the storage may further store information about a device type.

The storage may be a volatile memory or a non-volatile memory, or may include both a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and is used as an external cache. By way of example but not limited description, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

An embodiment of this application further provides a chip. The chip includes at least one processor in the foregoing embodiment and a reset-safe non-volatile storage medium communicatively connected to the processor. For example, the chip further includes a reset module. The reset module is communicatively connected to a control module in the processor, and the reset module is configured to send a reset indication to the control module. For example, the chip further includes an input interface, an output interface, and a storage. The storage includes the foregoing reset-safe non-volatile storage medium. The input interface, the output interface, the processor, and the storage are connected through an internal connection path.

All or some of the foregoing method embodiments may be implemented by using hardware, firmware, or any combination thereof. When software is used to implement embodiments, all or some of embodiments may be implemented in a form of a computer program or a computer program product. The computer program or the computer program product includes one or more computer instructions. When the computer program instructions are loaded and executed on a computer, procedures or functions according to this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk drive, or a magnetic tape), or an optical medium (for example, a digital versatile disc (digital versatile disc, DVD)), a semiconductor medium (for example, a solid-state drive (solid-state drive, SSD)), or the like.

To clearly describe the interchangeability of hardware and software, the steps and composition of embodiments have been generally described in the foregoing descriptions based on functions. Whether the functions are performed by hardware or software depends on particular applications and design constraint conditions of the technical solutions. A person of ordinary skill in the art may use different methods to implement the described functions for each particular application, but it should not be considered that the implementation goes beyond the scope of this application.

Computer program code used to implement the method in embodiments of this application may be written in one or more programming languages. The computer program code may be provided for a processor of a general-purpose computer, a dedicated computer, or another programmable data forwarding apparatus, so that when the program code is executed by the computer or the another programmable data forwarding apparatus, functions/operations specified in the flowcharts and/or block diagrams are implemented. The program code may be executed entirely on a computer, partly on a computer, as a standalone software package, partly on a computer and partly on a remote computer, or entirely on a remote computer or a server.

In the context of embodiments of this application, computer program code or related data may be carried in any appropriate carrier, so that the device, the apparatus, or the processor can perform various types of processing and operations described above. Examples of the carrier include a signal, a computer-readable medium, and the like. Examples of the signal may include an electrical signal, an optical signal, a radio signal, a voice signal, or other forms of propagated signals, such as a carrier wave and an infrared signal.

It may be clearly understood by a person skilled in the art that, for the purpose of convenient and brief description, for a detailed working process of the foregoing processor, board, device, and module, refer to a corresponding process in the foregoing method embodiments. Details are not described herein again.

In the several embodiments provided in this application, it should be understood that the disclosed processor, board, device, and method may be implemented in other manners. For example, the foregoing described device embodiments are merely examples. The module division is merely logical function division and may be other division in an actual implementation. For example, a plurality of modules or components may be combined or integrated into another system, or some features may be ignored or not performed. In addition, the displayed or discussed mutual couplings or direct couplings or communication connections may be indirect couplings or communication connections implemented through some interfaces, devices, or modules, or may be connections in electrical, mechanical, or other forms.

The modules described as separate components may or may not be physically separate, and components displayed as modules may or may not be physical modules, in other words, may be located in one place or may be distributed on a plurality of network modules. Some or all of the modules may be selected based on actual requirements to implement the objectives of the solutions of embodiments of this application.

In addition, functional modules in embodiments of this application may be integrated into one processing module, or each of the modules may exist alone physically, or two or more modules may be integrated into one module. The integrated module may be implemented in a form of hardware, or may be implemented in a form of a software functional module.

In this application, the terms "first", "second", and the like are used to distinguish between identical or similar items with substantially the same effects and functions. There is no logical or temporal dependency between the "first", "second", and "n^{th}", and no limitation is imposed on a quantity and an execution order. It should be further understood that although the following descriptions use terms such as "first" and "second" to describe various elements, these elements should not be limited by the terms. These terms are simply used to distinguish one element from another. For example, without departing from the scope of the various examples, a first register may be referred to as a second register, and similarly, a second register may be referred to as a first register.

It should be further understood that sequence numbers of processes do not mean execution sequences in embodiments of this application. The execution sequences of the processes should be determined based on functions and internal logic of the processes, and should not be construed as any limitation on the implementation processes of embodiments of this application.

In this application, the term "at least one" means one or more, and the term "a plurality of" in this application means two or more. For example, a plurality of second packets means two or more second packets. The terms "system" and "network" are often used interchangeably in this specification.

It should be understood that the terms used in the descriptions of the various examples in this specification are merely intended to describe specific examples and are not intended to impose a limitation. The terms "one" ("a" and "an") and "the" of singular forms used in the descriptions of the various examples and the appended claims are also intended to include plural forms, unless otherwise specified in the context clearly.

It should further be understood that the term "include" (also referred to as "includes", "including", "comprises", and/or "comprising") used in this specification specifies presence of the stated features, integers, steps, operations, elements, and/or components, with presence or addition of one or more other features, integers, steps, operations, elements, components, and/or their components not excluded.

It should be further understood that, depending on the context, the phrase "if it is determined..." or "if [a stated condition or event] is detected" may be interpreted to mean "once determining" or "in response to determining..." or "once detecting [the stated condition or event]" or "in response to the detection of [the stated condition or event]".

It should be understood that determining B based on A does not mean that B is determined based only on A, and B may alternatively be determined based on A and/or other information.

It should be further understood that "one embodiment", "an embodiment", and "a possible implementation" mentioned throughout the specification mean that a specific feature, structure, or characteristic related to the embodiment or an implementation is included in at least one embodiment of this application. Therefore, "in one embodiment" or "in an embodiment" or "a possible implementation" appearing throughout the specification may not necessarily refer to a same embodiment. In addition, these particular features, structures, or characteristics may be combined in one or more embodiments in any appropriate manner.

## Claims

1. A processor, wherein the processor comprises a control module, a first register, and a cache, and the processor is communicatively connected to a reset-safe non-volatile storage medium;
the control module is configured to obtain a reset indication, wherein the reset indication is an indication generated when the processor runs abnormally;
the control module is further configured to obtain related information of the processor based on the reset indication, wherein the related information comprises at least one of register information of the first register or data stored in the cache; and
the control module is further configured to store the related information in the reset-safe non-volatile storage medium.

2. The processor according to claim 1, wherein the processor further comprises a second register, the second register is a register used when the processor runs, the first register is configured to record register information of the second register, the first register is a reset-safe non-volatile register, and the reset indication indicates to reset the processor; and
the control module is configured to indicate, based on the reset indication, the first register to stop recording the register information of the second register, and after the processor is reset based on the reset indication, obtain the register information of the first register.

3. The processor according to claim 2, wherein the second register comprises at least one of a program counter PC, a stack pointer SP, a frame pointer FP, a control register CR, or a link register LR.

4. The processor according to any one of claims 1 to 3, wherein the processor has a reset pin, and the reset pin is configured to generate the reset indication and transmit the reset indication to the control module.

5. The processor according to any one of claims 1 to 3, wherein the control module is communicatively connected to a reset module, and the reset module is configured to send the reset indication to the control module.

6. The processor according to any one of claims 1 to 5, wherein the reset-safe non-volatile storage medium comprises at least one of a reset-safe non-volatile memory inside the processor, a non-volatile storage medium inside the processor, a reset-safe non-volatile memory outside the processor, or a non-volatile storage medium outside the processor.

7. The processor according to any one of claims 1 to 6, wherein the control module is further configured to: after the processor is reset, obtain the related information from the reset-safe non-volatile storage medium, and generate a running abnormality record based on the related information.

8. A method for obtaining information, wherein the method is applied to a processor, the processor comprises a control module, a first register, and a cache, the processor is communicatively connected to a reset-safe non-volatile storage medium, and the method comprises:
obtaining, by the control module, a reset indication, wherein the reset indication is an indication generated when the processor runs abnormally;
obtaining, by the control module, related information of the processor based on the reset indication, wherein the related information comprises at least one of register information of the first register or data stored in the cache; and
storing, by the control module, the related information in the reset-safe non-volatile storage medium.

9. The method according to claim 8, wherein the processor further comprises a second register, the second register is a register used when the processor runs, the first register is configured to record register information of the second register, the first register is a reset-safe non-volatile register, and the reset indication indicates to reset the processor; and
the obtaining related information of the processor based on the reset indication comprises:
indicating, based on the reset indication, the first register to stop recording the register information of the second register; and
after the processor is reset based on the reset indication, obtaining the register information of the first register.

10. The method according to claim 9, wherein the second register comprises at least one of a program counter PC, a stack pointer SP, a frame pointer FP, a control register CR, or a link register LR.

11. The method according to any one of claims 8 to 10, wherein the processor has a reset pin;
the method further comprises:
generating, by the processor, the reset indication via the reset pin; and
transmitting the reset indication to the control module via the reset pin; and
the obtaining a reset indication comprises:
receiving the reset indication.

12. The method according to any one of claims 8 to 10, wherein the control module is communicatively connected to a reset module, and the reset module is configured to send the reset indication to the control module; and
the obtaining a reset indication comprises:
receiving the reset indication sent by the reset module.

13. The method according to any one of claims 8 to 12, wherein the reset-safe non-volatile storage medium comprises at least one of a reset-safe non-volatile memory inside the processor, a non-volatile storage medium inside the processor, a reset-safe non-volatile memory outside the processor, or a non-volatile storage medium outside the processor.

14. The method according to any one of claims 8 to 13, wherein the method further comprises:
after the processor is reset, obtaining, by the control module, the related information from the reset-safe non-volatile storage medium, and generating a running abnormality record based on the related information.

15. A board, wherein the board comprises the processor according to any one of claims 1 to 7 and a reset-safe non-volatile storage medium communicatively connected to the processor.

16. The board according to claim 15, wherein the board further comprises a reset module, the reset module is communicatively connected to a control module in the processor, and the reset module is configured to send a reset indication to the control module.

17. A network device, wherein the network device comprises at least one processor according to any one of claims 1 to 7 and a reset-safe non-volatile storage medium communicatively connected to the processor.

18. The network device according to claim 17, wherein the network device further comprises a reset module, the reset module is communicatively connected to a control module in the processor, and the reset module is configured to send a reset indication to the control module.

19. A network device, wherein the network device comprises at least one board according to claim 15 or 16.

20. A chip, wherein the chip comprises at least one processor according to any one of claims 1 to 7 and a reset-safe non-volatile storage medium communicatively connected to the processor.

21. The chip according to claim 20, wherein the chip further comprises a reset module, the reset module is communicatively connected to a control module in the processor, and the reset module is configured to send a reset indication to the control module.
